# EUROPÄISCHE PATENTSCHRIFT

(11) **EP 0 755 125 B1**
(45) Veröffentlichungstag und Bekanntmachung des Hinweises auf die Patenterteilung: **18.09.2002**
(21) Anmeldenummer: 96111312.3
(22) Anmeldetag: 12.07.1996
(51) Int. Cl.: H04B 1/30, H03D 7/16

(54) **Verfahren zur Reduzierung von Nebenempfangsstellen in Homodyn-Empfängern mit zeitvarianter Trägerfrequenz**
Method for the reduction of secondary receiving positions in homodyne receivers with time variable carrier frequency
Procédé pour la réduction des postes supplémentaires de réception dans des récepteurs homodynes avec la fréquence porteuse variable en temps

(30) Priorität: 18.07.1995 DE 19526171
(43) Veröffentlichungstag der Anmeldung: 22.01.1997
(73) Patentinhaber: SIEMENS AKTIENGESELLSCHAFT, 80333 München (DE)
(72) Erfinder: Eul, Hermann-Josef, Dr.-Ing., 85764 Oberschleissheim (DE)

(56) Entgegenhaltungen:
- EP-A- 0 647 016
- US-A- 4 736 390
- US-A- 5 428 836

## Beschreibung

Unter Homodyn-Empfängern versteht man im allgemeinen, den Teil eines Funkempfängers, bei dem ein empfangenes Trägerfrequenzsignal durch eine Mischung mit einem geeignet gewählten Oszillatorsignal in ein Zwischenfrequenzsignal umgesetzt wird, dessen Zwischenfrequenz gleich Null ist. Zur Erzeugung eines Zwischenfrequenzsignals mit der Frequenz null muß im Homodyn-Empfänger ein Oszillatorsignal lokal generiert werden, das eine der Trägerfrequenz des empfangenen Trägerfrequenzsignals entsprechenden Frequenz aufweist. Damit liegt das im Trägerfrequenzsignal enthaltene niederfrequente Signal direkt zur weiteren Auswertung in folgenden, dem Funkempfänger zugehörigen Einrichtungen vor. Diese Auswertung besteht z.B. in der Abtastung und Auswertung des im Trägerfrequenzsignal enthaltenden niederfrequenten Signals. Das niederfrequente Signal kann im Homodyn-Empfänger nur nach einer Komponente, oder nach beiden, d.h. der In-Phasen- und der Quadraturkomponente, ausgewertet werden. Derartige Homodyn-Empfänger sind wohlbekannt, z.B. aus den Kleinheubacher Berichten 1989, Band 33, "Etablierung der komplexen Meßfähigkeit eines homodynen Reflektometers durch unbekannte Standards mit Hilfe der Möbius-Transformation" von H.J.Eul, B.Schiek.

EP 0 647 016 A offenbart einen Homodynempfänger mit niederfrequenter Modulation des Localoszillators.

Soll das Prinzip des Homodyn-Empfängers auf den Empfang eines Trägerfrequenzsignals mit einer über der Zeit veränderlichen Trägerfrequenz erweitert werden, so muß auch das Lokaloszillatorsignal zeitvariabel sein. Entweder muß der Lokaloszillator schnell zwischen den Frequenzen umschalten können - schwer realisierbar - , oder mehrere Lokaloszillatoren, zwischen denen umgeschaltet wird, sind nötig. Bei der Umschaltung ergibt sich das Problem, daß ein HF-Umschalter zwischen den verschiedenen Oszillatorsignalen schnell und störungsfrei umschalten muß. Dies bedeutet hohe technische Anforderungen an den HF-Umschalter und damit hohen wirtschaftlichen Realisierungsaufwand.

Zeitvariante Trägerfrequenzen sind u.a. aus Mobilfunksystemen nach dem GSM-Standard bekannt. Der Empfangseinrichtung wird vor dem Wechsel der Trägerfrequenz, der Zeitpunkt des Wechsels und die neue Trägerfrequenz vom Sender mitgeteilt. Die Empfangseinrichtung kann damit einen weiteren Lokaloszillator auf die neue Trägerfrequenz abstimmen und zum richtigen Zeitpunkt auf das dort generierte Lokaloszillatorsignal umschalten.

Bei bisher bekannten Homodyn-Empfängern mit zeitvarianer Trägerfrequenz besteht die technologische Schwierigkeit, den Umschalter, der die hochfrequenten Oszillatorfrequenzen schaltet, so auszugestalten, daß er die hochfrequenten Signale ohne Nebenstellenempfang trennen kann.

Nebenstellenempfang tritt auf, wenn das Oszillatorsignal neben den Signalanteilen, die der Trägerfrequenz zuzuordnen sind, durch ein mangelhaftes Umschalten oder Störungen auch weitere Signalanteile, z.B. die des bisher genutzten Lokaloszillatorsignals, enthält.

Aufwendige Abschirmungen oder qualitativ hochwertige und damit aufwendig herzustellende Umschalter sind nötig, um den Nebenstellenempfang zu reduzieren und damit eine Blockierung und Desensibilisierung des Homodyn-Empfänger zu vermeiden.

Der Erfindung liegt die Aufgabe zugrunde, ein Verfahren zur Reduzierung von Nebenempfangsstellen in Homodyn-Empfängern mit zeitvarianter Trägerfrequenz anzugeben, das mit einfachen und wirtschaftlichen Mitteln zu realisieren ist. Die Aufgabe wird ausgehend vom Verfahren nach den Merkmalen des Oberbegriffs des Anspruchs 1 durch dessen kennzeichnende Merkmale gelöst. In einem unabhängigen Anspruch wird ein erfindungsgemäßer Homodyn-Empfänger beschrieben.

Der wesentliche Aspekt der Erfindung besteht in einer Nutzung eines zusätzlichen Hilfssignals mit technologisch und mit wirtschaftlichem Aufwand beherrschbarer Frequenz. Dieses Hilfssignal wird vor der Mischung auf das Lokaloszillatorsignal moduliert und ermöglicht eine bessere Trennung der verschiedenen Lokaloszillatorsignale. Nur das ausgewählte Lokaloszillatorsignal wird mit dem Hilfssignal moduliert, und durch eine Bandpaßfilterung nach der Mischung des Trägerfrequenzsignals mit dem Oszillatorsignal wird das empfangene niederfrequente Signal als Amplitude des Hilfssignals von Störkomponenten gefiltert. Der Nebenstellenempfang wird damit verringert oder ganz vermieden.

Das Schaltmittel zur Auswahl des Lokaloszillatorsignals entsprechend der aktuellen Trägerfrequenz kann damit einfacher und wirtschaftlicher gestaltet werden, da nicht mehr das Schaltmittel allein die Lokaloszillatorsignale trennt. Diese Überlegung ist für einen Einsatz in Massenartikeln, wie in mobilen und drahtlosen Kommunikationssystemen, von besonderer wirtschaftlicher Bedeutung.

Vorteilhafterweise wird das empfangene niederfrequente Signal vollständig, d.h. sowohl nach In-Phasen-Komponente als auch nach Quadraturkomponente, ausgewertet und das Trägerfrequenzsignal zusätzlich mit dem der aktuellen Trägerfrequenz zuordenbaren, um 90° phasenverschobenen Oszillatorsignal zu einem zweiten Zwischenfrequenzsignal gemischt und das zweite Zwischenfrequenzsignal entsprechend einer der dem Hilfssignal zugeordneten Frequenz bandpaßgefiltert - Anspruch 2.

Die Zuschaltung des Hilfssignal zur Modulation des ausgewählten Lokaloszillatorsignals mittels eines zusätzlichen Schaltmittels wird synchron mit der Auswahl des Lokaloszillatorsignals durch das Schaltmittel für die Hochfrequenz durchgeführt - Anspruch 3. Es kann gemäß dieser vorteilhaften Weiterbildung das gleiche Steuersignal für beide Schaltmittel genutzt werden.

Die Bandfilterung des ersten und zweiten Zwischenfrequenzsignals wird in der einfachsten Realisierung des erfindungsgemäßen Verfahrens jeweils auf die Frequenz des Hilfssignals abgestimmt - Anspruch 4. Die Trennung des empfangenen, niederfrequenten Signals von weiteren unerwünschten Frequenzanteilen läßt sich so mit einem wirtschaftlich und einfach zu realisierenden Bandpaßfilter verwirklichen.

Nach einer weiteren vorteilhaften Ausbildung des erfindungsgemäßen Verfahrens wird das Trägerfrequenzsignal vor der Mischung mit einem Zusatzsignal moduliert. Zur Bandfilterung des Zwischenfrequenzsignals wird jeweils ein auf die Frequenzdifferenz der Frequenzen des Zusatzsignals und des Hilfssignals abgestimmtes Bandpaßfilter eingesetzt - Anspruch 5. Aus der Vielzahl der nach der Mischung vorliegenden Frequenzanteile wird somit ein Signal durch die Bandfilterung ausgewählt, das eine Frequenz mit der Differenz der Frequenzen des Zusatzsignals und des Hilfssignals aufweist - Anspruch 7. Durch entsprechende Wahl der genannten Frequenzen kann ein hochempfindlicher Empfänger konstruiert werden, da die herausgefilterte Frequenz weitgehend von den in der Empfangseinrichtung generierten Frequenzanteilen ist und keinen Störeinflüssen unterliegt.

Dabei kann die Frequenz des Hilfssignals zwischen den Frequenzen des niederfrequenten Signals und des Trägerfrequenzsignal liegen, so daß für diese Frequenz wirtschaftlich realisierbare Umschalter und Bandfilter einsetzbar sind - Anspruch 6.

Weiter vorteilhafte Ausgestaltungen der Erfindung, insbesondere die Ausgestaltung eines Homodyn-Empfängers sind den weiteren Ansprüchen zu entnehmen.

Die Erfindung soll nun anhand dreier Blockschaltbilder eines Homodyn-Empfängers näher erläutert werden.

Dabei zeigen
- FIG 1: ein Blockschaltbild eines Homodyn-Empfängers mit Hilfsmodulation zum Empfang eines Trägerfrequenzsignals mit zeitvarianter Trägerfrequenz,
- FIG 2: ein Blockschaltbild eines Homodyn-Empfängers mit Hilfsmodulation zum Empfang der In-Phasen- und Quadraturkomponente eines Trägerfrequenzsignals mit zeitvarianter Trägerfrequenz und
- FIG 3: ein Blockschaltbild eines Homodyn-Empfängers mit zweifacher Hilfsmodulation zum Empfang der In-Phasen- und Quadraturkomponente eines Trägerfrequenzsignals mit zeitvarianter Trägerfrequenz.

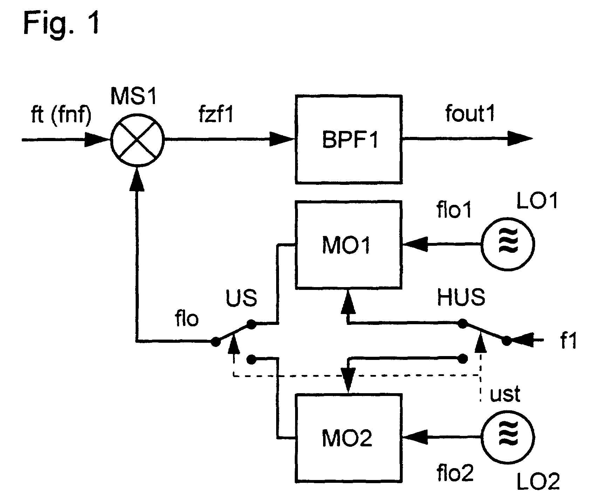

Die in FIG 1 bis 3 dargestellten Homodyn-Empfänger dienen dem Empfang eines mit einem niederfrequenten Signal fnf modulierten Trägerfrequenzsignals ft mit zeitvarianter Trägerfrequenz und der Umsetzung des empfangenen Signals ins Basisband. Die Frequenz des Trägerfrequenzsignals ft ändert sich zu dem Empfänger bekannten, vorbestimmten Zeitpunkten. Beispielhaft werden in diesen Ausführungsformen des Homodyn-Empfängers zwei Lokaloszillatoren LO1, LO2 angenommen, die Lokaloszillatorsignale flo1, flo2 mit den jeweiligen Trägerfrequenzen erzeugen können. Ändert sich die Trägerfrequenz des Trägerfrequenzsignales ft von einer ursprünglichen zu einer neuen Trägerfrequenz, so muß auch von dem das Signal mit der ursprünglichen Trägerfrequenz erzeugenden Lokaloszillator, z.B. dem ersten Lokaloszillator LO1, auf den das Signal mit der neuen Trägerfrequenz generierenden zweiten Lokaloszillator LO2 umgeschaltet werden. Nach dem Umschaltvorgang kann der erste Lokaloszillator LO1 auf die Generierung eines Signales mit der zukünftigen Trägerfrequenz vorbereitet werden, und der Umschaltvorgang kann sich wiederholen.

Beim Homodyn-Empfänger nach FIG 1 ist der erste Lokaloszillator LO1 mit einem ersten Modulator MO1 verbunden und führt diesem ein erstes Lokaloszillatorsignal flo1 zu. Gleiches gilt für einen zweiten Lokaloszillator LO2, der mit dem zweiten Modulator MO2 verbunden ist und diesem ein zweites Lokaloszillatorsignal flo2 zuführt.

Ein im Vergleich zu den Lokaloszillatorsignalen flo1, flo2 niederfrequentes Hilfssignal f1 wird über einen Hilfsumschalter HUS einem der mit dem Hilfsumschalter HUS verbundenen Modulatoren MO1, MO2 zugeführt. Der Hilfsumschalter HUS wird dabei vom Steuersignal ust gesteuert. Zu den dem Empfänger vorbekannten Zeitpunkten des Umschaltens der Trägerfrequenz wird durch die Steuerspannung ust das Hilfsignal f1 auf den Modulator, in FIG 1 der erste Modulator MO1, geschaltet, dem ein Lokaloszillatorsignal - hier erstes Lokaloszillatorsignal flo1 - mit Trägerfrequenz zugeführt wird.

Der Ausgang beider Modulatoren MO1, MO2 ist mit jeweils einem Kontakt eines Umschalters US verbunden. Dieser Umschalter US ist im Ausführungsbeispiel zweistufig und wird ebenfalls durch die Steuerspannung ust gesteuert. Der Umschalter US schaltet dadurch synchron mit dem Hilfsumschalter HUS. Durch das Umschalten des für Hochfrequenzsignale tauglichen Umschalters US wird jeweils das Modulationsergebnis einer der beiden Modulatoren MO1, MO2 als Oszillatorsignal flo ausgewählt und festgelegt. Das Oszillatorsignal flo enthält folglich ständig Frequenzanteile des Lokaloszillatorsignals mit der dem Trägerfrequenzsignal entsprechenden Frequenz, das zusätzlich mit dem Hilfssignal f1 moduliert ist.

Die Realisierung eines qualitativ hochwertigen HF-Umschalters ist aufwendig und kostenintensiv. Durch die Hilfsmodulation mit dem Hilfssignal f1 ist eine weniger aufwendige Ausführung eines HF-Umschalters möglich, da die Trennung der Hochfrequenzsignale der Lokaloszillatoren geringeren Anforderungen unterworfen ist. Wenn also das Oszillatorsignal flo im Ausführungsbeispiel auch Anteile des zweiten Lokaloszillatorsignals flo2 enthält, so ist dieses zweite Lokaloszillatorsignal flo2 nicht mit dem Hilfssignal f1 moduliert und damit später wieder trennbar. Bekannte Probleme der Genauigkeit des HF-Umschalters US, die bisher kostspielige Realisierungen dieses Umschalters zur Folge hatten, werden somit vermieden. Da der Hilfsumschalter HUS, der den druch das Steuersignal ust ausgewählten Modulator MO1 oder MO2 zur Modulation mit dem Hilfssignal f1 auswählt, ein Signal mit wesentlich geringeren und technologisch auch mit geringerem Aufwand beherrschbaren.Frequenzen schaltet, entsteht durch den zweiten Umschalter kein wesentlicher wirtschaftlicher Mehraufwand.

Das Oszillatorsignal flo wird einem Eingang einer ersten mit dem Umschalter US verbundenen Mischstufe MS1 zugeführt. Ein zweiter Eingang der ersten Mischstufe MS1 ist mit einem Eingang E des Homodyn-Empfängers verbunden, der das Trägerfrequenzsignal ft führt. Dieses Trägerfrequenzsignal ft ist beispielsweise das vorverstärkte Eingangssignal der Empfangseinrichtung und enthält das niederfrequente Signal fnf, z.B. Sprachsignal in einer Fernsprechanwendung des Homodyn-Empfängers. Das Modulationsverfahren, nach dem das niederfrequente Signal fnf auf das Trägerfrequenzsignal ft moduliert ist, ist für die Funktionsweise des Homodyn-Empfängers ohne Belang. Ein übliches Modulationsverfahren für Mobilfunkanwendungen ist z.B. die Phasenmodulation.

Im Ergebnis des Mischvorgangs in der ersten Mischstufe MS1 liegt am Ausgang der ersten Mischstufe MS1 ein erstes Zwischenfrequenzsignal fzf1. Da die Frequenz des ersten Lokaloszillatorsignals flo1 und die Trägerfrequenz des Trägerfrequenzsiganl ft identisch sind, liegt eine Umsetzung des Eingangssignals ins Basisband vor. Die Wechselspannungsamplitude des Hilfssignales f1 ist nach der Mischung dem niederfrequenten Signal fnf proportional und steht als Information im ersten Zwischenfrequenzsignal fzf1 bereit. Der Ausgang der ersten Mischstufe MS1 ist mit dem Eingang eines ersten Bandpaßfilters BPF1 verbunden.

Das erste Zwischenfrequenzsignal fzf1 wird im ersten Bandpaßfilter BPF1 bandgefiltert, wobei das erste Bandpaßfilter BPF1 auf die Frequenz des Hilfssignal f1 abgestimmt ist. Das am Ausgang des ersten Bandpaßfilters BPF1 vorliegende erste Ausgangssignal fout1 enthält also keine Frequenzanteile, die auf die Lokaloszillatorsignale flo1, flo2 zurückgehen. Durch die Bandfilterung werden alle Frequenzanteile außer der des Hilfssignals f1 entfernt und ebenso alle Gleichspannungsanteile. Es wird folglich auch eine Kompensierung des Gleichspannungs-Offsets erreicht.

Das erste Ausgangssignal des Homodyn-Empfängers fout1 stellt ein weitgehend störungsfreies Empfangssignal weiteren Komponenten der Empfangsschaltung, nicht dargestellt, zur Abtastung und Demodulierung bereit. Handelt es sich bei der weiteren Auswertung des ersten Ausgangssignals fout1 um rein digitale Selektionsfilter und andere digitale Baugruppen, kann die Anforderung an das erste Bandpaßfilter auf die Erfüllung der Anti-Aliasing-Bedingung reduziert werden.

Anstelle der in FIG 1 dargestellten zwei Lokaloszillatoren LO1, LO2 kann jedoch auch eine der Zahl der möglichen Trägerfrequenzen entsprechende oder eine andere Anzahl von Lokaloszillatoren LO1, .. LOn eingesetzt werden, die zumindest teilweise ein in der Frequenz festes Lokaloszillatorsignal generieren. In diesem Fall ist der Umschalter US und der Hilfsumschalter HUS nicht zweistufig ausgebildet, sondern weist eine der Anzahl der Lokaloszillatoren entsprechende Stufenzahl auf.

In Mobilfunksystemen nach dem GSM-Standard oder Drahtlos-Kommunikationssystemen nach dem DECT-Standard werden sich in der Trägerfrequenz ändernde Trägerfrequenzsignale verwendet, so daß sowohl in Basis- als auch in Mobilstationen Empfangsschaltungen zum Empfang solcher Signale mit zeitvarianter Trägerfrequenz vorhanden sein müssen. Der erfindungsgemäße Homodyn-Empfänger eignet sich aufgrund seiner erheblich kostengünstigeren Realisierungsmöglichkeit für derartige Massenanwendungen.

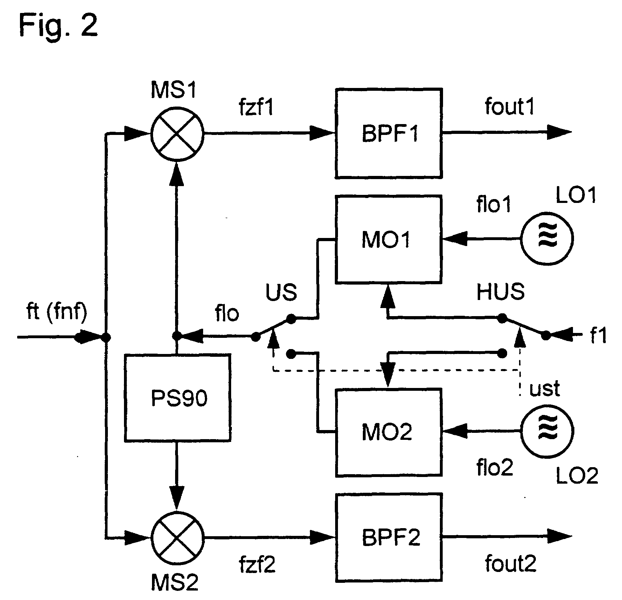

Der Homodyn-Empfänger in FIG 2 stellt eine Erweiterung des in FIG 1 erläuterten Empfangsprinzipes für den Empfang einer Quadraturkomponente zusätzlich zur In-Phasen-Komponente dar. Das Oszillatorsignal flo wird auf die zuvor erläuterte Weise erzeugt und neben der ersten Mischstufe MS1 auch einem 90°-Phasenschieber PS90 zugeführt, der ebenfalls mit dem Umschalter US verbunden ist. Im 90°-Phasenschieber PS90 wird die Phase des Oszillatorsignals flo um 90° gedreht und das so modifizierte Oszillatorsignal flo einer zweiten Mischstufe MS2 zugeführt. Ein weiterer Eingang der zweiten Mischstufe MS2 ist mit dem das Trägerfrequenzsignal ft führenden Eingang E des Homodyn-Empfängers verbunden, so daß am Ausgang der zweiten Mischstufe MS2 das zweite Zwischenfrequenzsignal fzf2 anliegt.

Der Ausgang der zweiten Mischstufe MS2 ist mit einem Eingang eines zweiten Bandpaßfilters BPF2 verbunden. Dieses zweite Bandpaßfilter BPF2 ist wie das erste Bandpaßfilter BPF1 auf die Frequenz des Hilfssignals f1 abgestimmt. Folglich stellt das zweite Bandpaßfilter BPF2 nach der Bandfilterung des zweiten Zwischenfrequenzsignals fzf2 an seinem Ausgang ein zweites Ausgangssignal fout2 bereit. Die Amplitude dieses zweiten Ausgangssignals fout2 ist der Quadraturkomponente des Trägerfrequenzsignals ft proportional. Auch dieses zweite Ausgangssignal fout2 wird wie das erste Ausgangssignal fout1 in weiteren Komponenten der Empfangseinrichtung abgetastet und ausgewertet. Mit den zwei Ausgangssignalen fout1, fout2 steht nun jedoch eine vollständige Information nach Amplitude und Phase über das niederfrequente Signal fnf für die folgende Auswertung zur Verfügung.

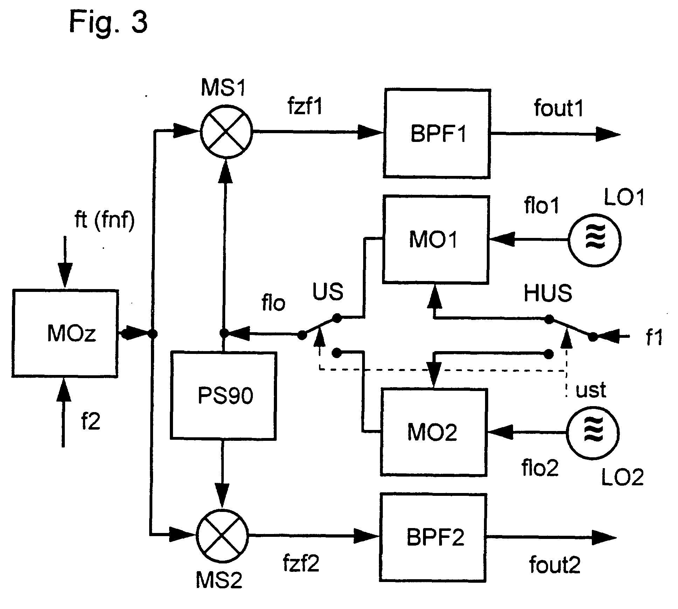

Der Homodyn-Empfänger entsprechend der Ausführungsform in FIG 3 basiert auf dem Homodyn-Empfänger, der in FIG 2 beschrieben ist, der jedoch zwei Veränderungen aufweist. Das Trägerfrequenzsignal ft wird vor der Mischung in einem zusätzlichen Modulator MOz, der ebenfalls dem Homodyn-Empfänger zugehörig ist, mit einem Zusatzsignal f2 moduliert. Der Ausgang des zusätzlichen Modulators MOz ist jeweils mit einem Eingang der ersten und zweiten Mischstufe MS1, MS2 verbunden und führt den beiden Mischstufen MS1, MS2 das Modulationsergebnis zu.

Am Ausgang der beiden Mischstufen MS1 und MS2 steht folglich unter anderem auch ein Signal mit einer Frequenz, die dem Betrag der Frequenzdifferenz f3 des Zusatzsignals f2 und des Hilfssignals f1 entspricht, zur Verfügung. Auf eben diese Frequenz f3 sind das erste Bandpaßfilter BPF1 und das zweite Bandpaßfilter BPF2 abgestimmt. Werden die Frequenzen des Hilfssignals f1 und des Zusatzsignals f2 so vorbestimmt, daß die Frequenzdifferenz f3 keiner weiteren im Homodyn-Empfänger oder anderen Einrichtungen der Empfangseinrichtung direkt generierten Frequenzanteilen entspricht, kann eine erhebliche Steigerung der Empfindlichkeit des Homodyn-Empfängers erreicht werden. Ist der Betrag der Frequenzdifferenz f3 kleiner der Frequenz des Hilfssignals f1 und des Zusatzsignals f2 scheiden auch interne Störungen durch Oberwellen der Mischsignale aus.

## Patentansprüche

1. Verfahren zur Reduzierung von Nebenempfangsstellen in Homodyn-Empfängern mit zeitvarianter Trägerfrequenz,
- bei dem ein empfangenes, mit einem niederfrequenten Signal (fnf) moduliertes Trägerfrequenzsignal (ft) zeitvarianter Trägerfrequenz mit einem der aktuellen Trägerfrequenz zuordenbaren, aus einem Lokaloszillatorsignal (flo1,.. flon) abgeleitetes Oszillatorsignal (flo) zu einem ersten Zwischenfrequenzsignal (fzf1) gemischt wird,
- wobei durch Schaltmittel (US) ein Lokaloszillatorsignal (flo1,.. flon) zur Ableitung des Oszillatorsignal (flo) ausgewählt wird und die Frequenz des ausgewählten Lokaloszillatorsignals (flo1,.. flon) der aktuellen Trägerfrequenz des Trägerfrequenzsignal (ft) entspricht,
**dadurch gekennzeichnet,**
- **daß** das Oszillatorsignal (flo) durch Modulation des ausgewählten Lokaloszillatorsignals (flo1,.. flon) mit einem Hilfssignal (f1) abgeleitet wird und
- **daß** das erste Zwischenfrequenzsignal (fzf1) entsprechend einer der dem Hilfssignal (f1) zugeordneten Frequenz bandpaßgefiltert wird.

2. Verfahren nach Anspruch 1,
**dadurch gekennzeichnet,**
**daß** zusätzlich das Trägerfrequenzsignal (ft) mit dem der aktuellen Trägerfrequenz zuordenbaren, um 90° phasenverschobenen Oszillatorsignal (flo) zu einem zweiten Zwischenfrequenzsignal (fzf2) gemischt wird und
**daß** das zweite Zwischenfrequenzsignal (fzf2) entsprechend einer der dem Hilfssignals (f1) zugeordneten Frequenz bandpaßgefiltert wird.

3. Verfahren nach Anspruch 1 oder 2,
**dadurch gekennzeichnet,**
**daß** durch zusätzliche Schaltmittel (HUS) das Hilfssignal (f1) zur Modulation des ausgewählten Lokaloszillatorsignals (flo1,.. flon) synchron mit der Auswahl des Lokaloszillatorsignals (flo1,.. flon) zugeschaltet wird.

4. Verfahren nach Anspruch 2 oder 3,
**dadurch gekennzeichnet,**
**daß** die Bandfilterung des ersten und zweiten Zwischenfrequenzsignals (fzf1, fzf2) jeweils auf die Frequenz des Hilfssignals (f1) abgestimmt ist.

5. Verfahren nach Anspruch 1 bis 3,
**dadurch gekennzeichnet,**
**daß** das Trägerfrequenzsignal (ft) vor der Mischung mit einem Zusatzsignal (f2) moduliert wird und die Bandfilterung des zumindest einen Zwischenfrequenzsignals (fzf1, fzf2) jeweils auf die Frequenzdifferenz (f3) der Frequenzen des Zusatzsignals (f2) und des Hilfssignals (f1) abgestimmtet ist.

6. Verfahren nach einem der vorhergehenden Ansprüche,
**dadurch gekennzeichnet,**
**daß** die zwischen den Frequenzen des niederfrequenten Signals (fnf) und des Trägerfrequenzsignal (ft) liegende Frequenz des Hilfssignals (f1) auf eine Frequenz abgestimmt ist, bei der wirtschaftlich realisierbare Umschalter und Bandfilter einsetzbar sind.

7. Verfahren nach Anspruch 5 und 6,
**dadurch gekennzeichnet,**
**daß** die Frequenz des Zusatzsignals (f2) so gewählt wird, daß der Betrag der Frequenzdifferenz (f3) kleiner der Frequenz des Zusatzsignals (f2) und der Frequenz des Hilfssignals (f1) ist und keiner im Homodyn-Empfänger generierten Frequenz entspricht.

8. Homodyn-Empfänger zur Reduzierung von Nebenempfangsstellen beim Empfang eines mit einem niederfrequenten Signal (fnf) modulierten Trägerfrequenzsignals (ft) mit zeitvarianter Trägerfrequenz
mit zwei Mischstufen (MS1, MS2), die eingangsseitig jeweils mit dem Eingang (E) des Homodyn-Empfängers und direkt bzw. über einen 90°-Phasenschieber (PS90) mit einem Umschalter (US) verbunden sind,
- wobei durch den mittels eines Steuersignals (ust) gesteuerten Umschalter (US) ein ein Lokaloszillatorsignal (flo1,.. flon) entsprechend der Trägerfrequenz des Trägerfrequenzsignals (ft) generierenden lokalen Oszillator (LO1,.. LOn) zur Verbindung mit der ersten Mischstufe (MS1) und dem 90°-Phasenschieber (PS90) ausgewählt wird und
- wobei das Trägerfrequenzsignals (ft) in der ersten Mischstufe (MS1) mit einem der jeweiligen Trägerfrequenz und damit einem der Lokaloszillatorsignale (flo1,.. flon) zuordenbaren Oszillatorsignal (flo) und in der zweiten Mischstufe (MS2) mit dem im 90°-Phasenschieber (PS90) um 90° verschobenen Oszillatorsignal (flo) zu jeweils einem am Ausgang der Mischstufen (MS1, MS2) anliegenden Zwischenfrequenzsignal (fzf1, fzf2) gemischt wird,
**dadurch gekennzeichnet,**
- **daß** der Umschalter (US) mit jedem lokalen Oszillator (LO1,.. LOn) über jeweils einen Modulator (MO1,.. MOn) zur Modulation des der aktuellen Trägerfrequenz entsprechenden Lokaloszillatorsignal (flo1,.. flon) mit einem Hilfssignal (f1) zum Oszillatorsignal (flo) verbunden wird,
- wobei das Hilfssignal (f1) über einen zusätzlichen Hilfsumschalter (HUS) dem Modulator (MO1, M02, .. MOn) zugeführt wird, der zu diesem Zeitpunkt mit dem Umschalter (US) verbunden ist, und
- **daß** der Ausgang der ersten Mischstufe (MS1) mit dem Eingang eines ersten Bandpaßfilters (BPF1) verbunden ist und der Ausgang der zweiten Mischstufe (MS2) mit dem Eingang eines zweiten Bandpaßfilters (BPF2) verbunden ist,
- wobei die Bandpaßfilter (BPF1, BPF2) jeweils entsprechend einer der dem Hilfssignals (f1) zuordenbaren Frequenz abgestimmt sind, so daß am Ausgang des ersten Bandpassfilters (BPF1) ein dem Realteil des niederfrequenten Signals (fnf) proportionales Signal (fout1) und am Ausgang des zweiten Bandpassfilters (BPF2) ein dem dem Imaginärteil des niederfrequenten Signals (fnf) proportionales Signal (fout2) anliegt.

9. Homodyn-Empfänger nach Anspruch 8,
**dadurch gekennzeichnet,**
**daß** das Hilfssignal (f1) zur Modulation des zugeordneten Lokaloszillatorsignals (flo1,.. flon) mittels des durch das Steuersignal (ust) gesteuerten Hilfsumschalter (HUS) synchron mit der Auswahl des Lokaloszillatorsignals Lokaloszillatorsignals (flo1,.. flon) zugeschaltet wird.

10. Homodyn-Empfänger nach Anspruch 8 oder 9,
**dadurch gekennzeichnet,**
**daß** die Bandpaßfilter (BPF1, BPF2) zur Bandfilterung des ersten und zweiten Zwischenfrequenzsignals (fzf1, fzf2) auf die Frequenz des Hilfssignals (f1) abgestimmt sind.

11. Homodyn-Empfänger nach Anspruch 8 oder 9,
**dadurch gekennzeichnet,**
**daß** das der Eingang (E) des Homodyn-Funkempfängers dem Ausgang eines zusätzlichen, dem Homodyn-Funkempfängers zugehörigen Modulators (MOz) entspricht,
- in dem das Trägerfrequenzsignal (ft) vor der Mischung in den Mischstufen (MS1, MS2) mit einem Zusatzsignal (f2) moduliert wird, und
**daß** die Bandpaßfilter (BPF1, BPF2) zur Bandfilterung des ersten und zweiten Zwischenfrequenzsignals (fzfl, fzf2) auf die Frequenzdifferenz (f3) der Frequenzen des Zusatzsignals (f2) und des Hilfssignals (f1) abgestimmt sind.

12. Homodyn-Empfänger nach einem der Ansprüche 8 bis 11,
**dadurch gekennzeichnet,**
**daß** die Frequenz des Hilfssignals (f1) zwischen den Frequenzen des niederfrequenten Signals (fnf) und des Trägerfrequenzsignal (ft) in einem Frequenzbereich einfach und kostengünstig realisierbarer Umschalter und Bandfilter festgelegt ist.

13. Homodyn-Empfänger nach Anspruch 11 und 12,
**dadurch gekennzeichnet,**
**daß** die Frequenzen des Hilfsignals (f1) und des Zusatzsignals (f2) so gewählt werden, daß der Betrag der Frequenzdifferenz (f3) kleiner der Frequenz des Zusatzsignals (f2) und der Frequenz des Hilfssignals (f1) ist und keinem im Homodyn-Empfänger generierten Frequenzanteil entspricht.

14. Homodyn-Empfänger nach einem der Ansprüche 8 bis 13,
**dadurch gekennzeichnet,**
**daß** der Umschalter (US) als zweistufiger Umschalter ausgebildet ist und
**daß** der Umschalter (US) zwischen zwei, mit dem Umschalter (US) über jeweils einen Modulator (MO1, MO2) verbundenen lokalen Oszillatoren (LO1, LO2) auswählt,
- wobei der ausgewählte lokale Oszillator (LO1, LO2) die aktuelle Trägerfrequenz generiert und der andere lokale Oszillator (LO1, LO2) auf die nächstfolgende Trägerfrequenz abgestimmt wird.

## Claims

1. Method for reducing spurious-response positions in homodyne receivers with time-variant carrier frequency,
- in which a received carrier frequency signal (ft) of time-variant carrier frequency, modulated with a low-frequency signal (fnf), is mixed with an oscillator signal (flo), which can be correlated with the current carrier frequency and is derived from a local-oscillator signal (flo1, .. flon), to form a first intermediate-frequency signal (fzf1),
- in which a local-oscillator signal (flo1, .. flon) is selected by switching means (US) for deriving the oscillator signal (flo) and the frequency of the selected local-oscillator signal (flo1, .. flon) corresponds to the current carrier frequency of the carrier-frequency signal (ft),
**characterized in that**
- the oscillator signal (flo) is derived by modulating the selected local-oscillator signal (flol, .. flon) with an auxiliary signal (f1), and
- **in that** the first intermediate-frequency signal (fzf1) is band-pass filtered in accordance with a frequency allocated to the auxiliary signal (f1).

2. Method according to Claim 1,
**characterized in that**
the carrier-frequency signal (ft) is additionally mixed with the oscillator signal (flo), which is phase shifted by 90° and can be correlated with the current carrier frequency, to form a second intermediate-frequency signal (fzf2) and
**in that** the second intermediate-frequency signal (fzf2) is band-pass filtered in accordance with a frequency allocated to the auxiliary signal (f1).

3. Method according to Claim 1 or 2,
**characterized in that**
the auxiliary signal (f1) for modulating the selected local-oscillator signal (flo1, .. flon) is added synchronously to the selection of the local-oscillator signal (flo1, .. flon) by additional switching means (HUS).

4. Method according to Claim 2 or 3,
**characterized in that**
the band filtering of the first and second intermediate-frequency signals (fzf1, fzf2) is in each case tuned to the frequency of the auxiliary signal (f1).

5. Method according to Claims 1 to 3,
**characterized in that**
the carrier-frequency signal (ft) is modulated with an additional signal (f2) before the mixing and the band filtering of the at least one intermediate-frequency signal (fzf1, fzf2) is in each case tuned to the frequency difference (f3) between the frequencies of the additional signal (f2) and of the auxiliary signal (f1).

6. Method according to one of the preceding claims,
**characterized in that**
the frequency of the auxiliary signal (f1), which is located between the frequencies of the low-frequency signal (fnf) and of the carrier-frequency signal (ft), is tuned to a frequency at which change-over switches and band filters can be used which can be economically implemented.

7. Method according to Claims 5 and 6,
**characterized in that**
the frequency of the additional signal (f2) is selected in such a manner that the amount of the frequency difference (f3) is smaller than that of the frequency of the additional signal (f2) and of the frequency of the auxiliary signal (f1) and does not correspond to any frequency generated in the homodyne receiver.

8. Homodyne receiver for reducing spurious-response positions on reception of a carrier frequency signal (ft) with time-variant carrier frequency which is modulated with a low-frequency signal (fnf),
comprising two mixing stages (MS1, MS2) which are in each case connected at the input end to the input (E) of the homodyne receiver and directly and via a 90° phase shifter (PS90), respectively, to a change-over switch (US),
- in which the change-over switch (US) controlled by means of a control signal (ust) selects a local oscillator (LO1, .. LOn), generating a local-oscillator signal (flo1, .. flon) corresponding to the carrier frequency of the carrier-frequency signal (ft) for connection to the first mixing stage (MS1) and the 90° phase shifter (PS90), and
- in which the carrier-frequency signal (ft) is mixed in the first mixing stage (MS1) with an oscillator signal (flo) which can be correlated with the respective carrier frequency and thus with one of the local-oscillator signals (flol, ...flon) and in the second mixing stage (MS2) with the oscillator signal (flo) shifted by 90° in the 90° phase shifter (PS90) to form in each case an intermediate-frequency signal (fzf1, fzf2) present at the output of the mixing stages (MS1, MS2),
**characterized in that**
- the change-over switch (US) is connected to each local oscillator (LO1, .. LOn) via in each case one modulator (MO1, .. MOn) for modulating the local-oscillator signal (flol, .. flon), corresponding to the current carrier frequency, to form the oscillator signal (flo),
- in which the auxiliary signal (f1) is supplied via an additional auxiliary change-over switch (HUS) to the modulator (MO1, MO2, .. MOn) which is connected to the change-over switch (US) at this time, and
- **in that** the output of the first mixing stage (MS1) is connected to the input of a first band-pass filter (BPF1) and the output of the second mixing stage (MS2) is connected to the input of a second band-pass filter (BPF2),
- in which the band-pass filters (BPF1, BPF2) are in each case tuned in accordance with a frequency which can be correlated with the auxiliary signal (f1) so that a signal (foutl) proportional to the real component of the low-frequency signal (fnf) is present at the output of the first band pass filter (BPF1) and a signal (fout2) proportional to the imaginary component of the low-frequency signal (fnf) is present at the output of the second band-pass filter (BPF2).

9. Homodyne receiver according to Claim 8,
**characterized in that**
the auxiliary signal (f1) is added synchronously with the selection of the local-oscillator signal (flo1, .. flon) by means of the auxiliary change-over switch (HUS) controlled by the control signal (ust) for modulating the associated local-oscillator signal (flo1, .. flon).

10. Homodyne receiver according to Claim 8 or 9,
**characterized in that**
the band-pass filters (BPF1, BPF2) are tuned to the frequency of the auxiliary signal (f1) for band-filtering the first and second intermediate-frequency signal (fzf1, fzf2).

11. Homodyne receiver according to Claim 8 or 9,
**characterized in that**
the input (E) of the homodyne radio receiver corresponds to the output of an additional modulator (MOz) belonging to the homodyne radio receiver,
- in which modulator the carrier-frequency signal (ft) is modulated with an additional signal (f2) before being mixed in the mixing stages (MS1, MS2), and
**in that** the band-pass filters (BPF1, BPF2) are tuned to the frequency difference (f3) between the frequencies of the additional signal (f2) and of the auxiliary signal (f1) for band-filtering the first and second intermediate-frequency signal (fzf1, fzf2).

12. Homodyne receiver according to one of Claims 8 to 11,
**characterized in that**
the frequency of the auxiliary signal (f1) is determined between the frequencies of the low-frequency signal (fnf) and of the carrier frequency signal (ft) in a frequency range of change-over switches and band-pass filters which can be implemented in a simple and inexpensive manner.

13. Homodyne receiver according to Claims 11 and 12,
**characterized in that**
the frequencies of the auxiliary signal (f1) and of the additional signal (f2) are selected in such a manner that the amount of the frequency difference (f3) is smaller than the frequency of the additional signal (f2) and of the frequency of the auxiliary signal (f1) and does not correspond to any frequency component generated in the homodyne receiver.

14. Homodyne receiver according to one of Claims 8 to 13,
**characterized in that**
the change-over switch (US) is constructed as a two-stage change-over switch and
**in that** the change-over switch (US) selects between two local oscillators (LO1, LO2) connected to the change-over switch (US) via one modulator (MO1, MO2) in each case,
- in which the selected local oscillator (LO1, LO2) generates the current carrier frequency and the other local oscillator (LO1, LO2) is tuned to the next carrier frequency.

## Revendications

1. Procédé destiné à réduire les postes secondaires de réception dans des récepteurs homodynes à fréquence porteuse variable dans le temps,
- dans lequel un signal à fréquence porteuse (ft), dont la fréquence porteuse est variable dans le temps, qui a été reçu et qui est modulé avec un signal basse fréquence (fnf), est mélangé avec un signal d'oscillateur (flo), qui correspond à la fréquence porteuse actuelle et qui est dérivé d'un signal d'oscillateur local (flo1, ..., flon), pour donner un premier signal à fréquence intermédiaire (fzf1),
- un signal d'oscillateur local (flo1, ..., flon) destiné à la formation du signal d'oscillateur (flo) étant sélectionné par des moyens de commutation (US) et la fréquence du signal d'oscillateur local sélectionné (flo1, ..., flon) correspondant à la fréquence porteuse actuelle du signal à fréquence porteuse (ft)
**caractérisé par le fait**
- **que** le signal d'oscillateur (flo) est formé par modulation du signal d'oscillateur local sélectionné (flo1, ..., flon) avec un signal auxiliaire (f1) et
- **que** le premier signal à fréquence intermédiaire (fzf1) est filtré par un passe-bande en fonction d'une fréquence qui correspond au signal auxiliaire (f1).

2. Procédé sefon la revendication 1
**caractérisé par** l e fait
que, en plus, le signal à fréquence porteuse (ft) est mélangé avec le signal d'oscillateur (flo), qui correspond à la fréquence porteuse actuelle et qui est déphasé de 90°, pour former un deuxième signal à fréquence intermédiaire (fzf2) et
que le deuxième signal à fréquence intermédiaire (fzf2) est filtré par un passe-bande en fonction d'une fréquence qui correspond au signal auxiliaire (f1).

3. Procédé selon la revendication 1 ou 2
**caractérisé par le fait**
**que**, grâce à des moyens supplémentaires de commutation (HUS), le signal auxiliaire (f1) est connecté, pour la modulation du signal d'oscillateur local (flo1, ..., flon) sélectionné, en synchronisation avec la sélection du signal d'oscillateur local (flo1, ..., flon).

4. Procédé selon la revendication 2 ou 3
**caractérisé par** l e fait
que le filtrage par passe-bande du premier et du deuxième signal à fréquence intermédiaire (fzf1, fzf2) est accordé, dans chaque cas, sur la fréquence du signal auxiliaire (f1).

5. Procédé selon la revendication 1 à 3
**caractérisé par** l e fait
que le signal à fréquence porteuse (ft) est modulé, avant le mélange, avec un signal supplémentaire (f2) et le filtrage par passe-bande du au moins un signal à fréquence intermédiaire (fzf1, fzf2) est accordé, dans chaque cas, sur la différence (f3) de fréquence entre les fréquences du signal supplémentaire (f2) et du signal auxiliaire (f1).

6. Procédé selon l'une des revendications précédentes
**caractérisé par le fait**
**que** la fréquence du signal auxiliaire (f1), qui se trouve entre les fréquences du signal basse fréquence (fnf) et du signal à fréquence porteuse (ft), est accordée sur une fréquence pour laquelle on peut utiliser des commutateurs et des filtres passe-bande réalisables d'une façon économique.

7. Procédé selon la revendication 5 et 6
**caractérisé par le fait**
**que** la fréquence du signal supplémentaire (f2) est choisie de telle sorte que la valeur de la différence (f3) entre les fréquences est inférieure à la fréquence du signal supplémentaire (f2) et à la fréquence du signal auxiliaire (f1) et qu'elle ne correspond à aucune fréquence générée dans le récepteur homodyne.

8. Récepteur homodyne destiné à réduire les postes secondaires de réception lors de la réception d'un signal à fréquence porteuse (ft), dont la fréquence porteuse est variable dans le temps, modulé avec un signal basse fréquence (fnf) ayant deux étages mélangeurs (MS1, MS2), qui sont reliés, du côté entrée chacun à l'entrée (E) du récepteur homodyne et directement et, respectivement, par l'intermédiaire d'un déphaseur de 90° (PS90) à un commutateur (US),
- un oscillateur local (LO1, ..., LOn), qui génère un signal d'osciliateur local (flo1, ..., flon) correspondant à la fréquence porteuse du signal à fréquence porteuse (ft) étant sélectionné par le commutateur (US), contrôlé au moyen d'un signal de commande (ust), pour la liaison avec le premier étage mélangeur (MS1) et le déphaseur pour 90° (PS90) et
- le signal à fréquence porteuse (ft) étant mélangé, dans le premier étage mélangeur (MS1), avec un signal d'oscillateur (flo) correspondant à la fréquence porteuse respective et, ainsi, à l'un des signaux d'oscillateur local (flo1, ..., flon) et, dans le second étage mélangeur (MS2), avec le signal d'oscillateur déphasé de 90 ° dans le déphaseur pour 90° pour former, dans chaque cas, un signal à fréquence intermédiaire (fzf1, fzf2) qui est délivré à la sortie des étages mélangeurs (MS1, MS2),
**caractérisé par le fait**
- **que** le commutateur (US) est relié à chaque oscillateur local (LO1, ..., LOn) par l'intermédiaire, dans chaque cas, d'un modulateur (MO1, ..., MOn) destiné à la modulation du signal d'oscillateur local (flo1, ..., flon), correspondant à la fréquence porteuse actuelle, avec un signal auxiliaire (f1) pour former le signal d'oscillateur (flo),
- le signal auxiliaire (f1) étant appliqué, par l'intermédiaire d'un commutateur auxiliaire supplémentaire (HUS), au modulateur (MO1, MO2, ..., MOn) qui est relié, à cet instant, au commutateur (US) et
- **que** la sortie du premier étage mélangeur (MS1) est reliée à l'entrée d'un premier filtre passe-bande (BPF1) et la sortie du deuxième étage mélangeur (MS2), à l'entrée d'un deuxième filtre passe-bande (BPF2),
- le filtre passe-bande (BPF1, BPF2) étant accordé, dans chaque cas, en fonction d'une fréquence correspondant au signal auxiliaire (f1), si bien que, à la sortie du premier filtre passe-bande (BPF1), on trouve un signal (fout1) proportionnel à la composante réelle du signal basse fréquence (fnf) et, à la sortie du deuxième filtre passe-bande (BPF2), on trouve un signal (fout2) proportionnel à la composante imaginaire du signal basse fréquence (fnf).

9. Récepteur homodyne selon la revendication 8
**caractérisé par le fait**
**que** le signal auxiliaire (f1) destiné à la modulation du signal d'oscillateur local correspondant (flo1, ..., flon) est connecté au moyen du commutateur auxiliaire (HUS), lequel est contrôlé par le signal de commande (ust), en synchronisation avec la sélection du signal d'oscillateur local (flo1, ..., flon).

10. Récepteur homodyne selon la revendication 8 ou 9
**caractérisé par le fait**
**que** les filtres passe-bande (BPF1, BPF2) destinés au filtrage passe-bande du premier et du deuxième signal à fréquence intermédiaire (fzf1, fzf2) sont accordés sur la fréquence du signal auxiliaire (f1).

11. Récepteur homodyne selon la revendication 8 ou 9
**caractérisé par le fait**
**que** l'entrée (E) du récepteur radio homodyne correspond à la sortie d'un modulateur supplémentaire (MOz) faisant partie du récepteur radio homodyne,
- dans lequel le signal à fréquence porteuse (ft) est modulé avec un signal supplémentaire (f2) avant le mélange dans les étages de mélange (MS1, MS2), et
**que** les filtres passe-bande (BPF1, BPF2) destinés au filtrage passe-bande du premier et du deuxième signal à fréquence intermédiaire (fzf1, fzf2) sont accordés sur la différence de fréquence (f3) entre la fréquence du signal supplémentaire (f2) et la fréquence du signal auxiliaire (f1).

12. Récepteur homodyne selon la revendication 8 à 11
**caractérisé par le fait**
**que** la fréquence du signal auxiliaire (f1) est fixée, entre les fréquences du signal basse fréquence (fnf) et du signal à fréquence porteuse (ft), dans une plage de fréquences de commutateurs et de filtres passe-bande faciles à réaliser à peu de frais.

13. Récepteur homodyne selon la revendication 11 et 12
**caractérisé par** l e fait
que les fréquences du signal auxiliaire (f1) et du signal supplémentaire (f2) sont choisies de telle sorte que la valeur de la différence de fréquence (f3) est inférieure à la fréquence du signal supplémentaire (f2) et à la fréquence du signal auxiliaire (f1) et ne correspond à aucune composante de fréquence générée dans le récepteur homodyne.

14. Récepteur homodyne selon l'une des revendications 8 à 13
**caractérisé par le fait**
**que** le commutateur (US) est conçu comme commutateur à deux étages et
**que** le commutateur (US) sélectionne l'un de deux oscillateurs locaux (LO1, LO2) reliés au commutateur (US) chacun à travers un modulateur (MO1, MO2),
- l'oscitlateur local (LO1, LO2) sélectionné générant la fréquence porteuse actuelle et l'autre oscillateur local (LO1, LO2) étant accordé sur la fréquence porteuse immédiatement suivante.
